# EUROPÄISCHE PATENTSCHRIFT

(11) **EP 0 902 615 B1**
(45) Veröffentlichungstag und Bekanntmachung des Hinweises auf die Patenterteilung: **12.09.2001**
(21) Anmeldenummer: 98810165.5
(22) Anmeldetag: 27.02.1998
(51) Int. Cl.: H05K 9/00

(54) **Baugruppenträger mit Abschirmblechen**
Electronic component with shielding sheets
Composant électronique avec tôles de blindage

(30) Priorität: 22.08.1997 DE 29715114 U
(43) Veröffentlichungstag der Anmeldung: 17.03.1999
(73) Patentinhaber: ELMA Electronic AG, 8620 Wetzikon (CH)
(72) Erfinder: Schindler, Walter A., 8055 Zürich (CH)
(74) Vertreter: Sulzer Management AG

(56) Entgegenhaltungen:
- EP-A- 0 828 411
- US-A- 5 436 802

## Beschreibung

Die Erfindung handelt von einem Baugruppenträger mit einem geraden und mit einem abgewinkelten Abdeckblech die eine Winkelverbindung für ein Gehäuse in den Abmessungen der Normen IEC 297 und IEC 917 bilden, wobei aus dem geraden Blech Haken herausgebogen sind, um einen Schenkel des abgewinkelten Blechs darin aufzunehmen.

In der Patentanmeldung EP-A-0 727 853 werden Baugruppenträger gezeigt, deren Gehäuse aus geraden und abgewinkelten Blechen zusammengesetzt sind. Im sich überdeckenden Bereich der Bleche sind an einer Kante Ausklinkungen gemacht worden, die steckbare Zungen stehen lassen, und am Gegenstück im gleichen Raster quer zu den Zügen Ösen ausgebogen, in welche die Zungen einsteckbar sind. Ein Nachteil dieser Anordnung ist, dass in der Trennebene zwischen den beiden Blechen ein gleicher Raster für Zungen und aufnehmende Ösen vorzusehen ist und dass dieser Raster bei beiden Blechen auch noch in der richtigen Lage zu den Begrenzungen des späteren Gehäuses liegen muss. Dies stellt bezüglich Fertigungsflexibilität eine Einschränkung dar.

Aufgabe der vorliegenden Erfindung ist es, eine lösbare Verbindung zu schaffen, die diese Nachteile im Rahmen der durch die IEC Normen 297 und 917 für die Gehäusestruktur zugestandenen Bereiche beseitigt. Diese Aufgabe wird gelöst, indem die Haken in einem Abstand I < 16 mm von einer Kante des geraden Blechs und auf der Innenseite des Gehäuses herausgeformt sind, und dass an den Haken eine elastische Kontaktfeder angeformt ist, die mit einem Noppen eine vorgegebene Kontaktfkraft auf dem eingeschobenen Schenkel erzeugt.

Eine solche Anordnung hat den Vorteil, dass für die abgewinkelten Bleche nur ein Werkzeug für das Abwinkeln benutzt werden kann. Da abgesehen von der Blechdicke des abgewinkelten Schenkels alle anderen Masse, die die Streuung der Kontaktkraft bestimmen, durch die Abmessungen in dem Werkzeug gegeben sind, welches die Lage der Noppen im geraden Blech festlegen, können die vorgegebenen Kontaktkräfte recht genau eingehalten werden. Ausserdem wird eine Überbeanspruchung der Kontaktfedern, die gerade bei Aluminiumblechen schnell zu einer plastischen Deformation führt, verhindert.

Die Unteransprüche 2 bis 9 stellen vorteilhafte Weiterbildungen der Erfindung dar. So kann der ausgebogene Hakenteil mit einer Sicke versehen werden, um diesen Teil noch steifer im Verhältnis zur anschliessenden Kontaktfeder zu gestalten. Es hat sich gezeigt, dass der abgewinkelte Schenkel direkt auf dem Hakenteil aufliegen kann, da er mit seinem der Blechdicke entsprechenden Hebelarm ein so geringes Biegemoment beim Aufliegen am Hakenteil erzeugt, dass die angeformte Kontaktfeder nur geringfügig beeinflusst wird. Falls wirklich ungewöhnlich hohe Kräfte in Einsteckrichtung vorgesehen sind, kann die Endlage des abgewinkelten Schenkels vor dem Erreichen des Hakenteils durch separate Anschläge aufgefangen werden.

Eine weitere Möglichkeit eine nachgiebige Kontaktfeder herzustellen besteht darin, sie vom Hakenteil zum Noppen hin zu verjüngen oder sonst zu schwächen. Dabei haben sich für die Bleche, aus denen Haken und Kontaktfedern herausgebogen werden, Wandstärken 0,5 ≤ d ≤ 2 mm als vorteilhaft erwiesen. Die Bleche können aus Aluminium oder Stahl sein, wobei wegen der durch die Norm IEC 297 und IEC 917 beschränkten Platzverhältnisse für Haken und Kontaktfeder ein Arbeitsbereich vor der plastischen Verformung der Kontaktfeder definiert werden kann, wenn deren Deformationsweg S beim Einschieben des Schenkels mindestens einem Wert 0,05 ≤ S mm entspricht und die Kontaktkraft P bei einem Aluminiumblech einem Wert P ≥ 3 N und bei einem Stahlblech einem Wert P ≥ 5 N entspricht. Die vorgeschlagene Lösung gestattet es also vernünftige Kontaktkräfte zu erzeugen, ohne bei einem wiederholtem Stecken plastische Deformationen und eine nennenswerte Reduktion der Kontaktkraft zu erzeugen.

Im folgenden wird die Erfindung anhand von Ausführungsbeispielen beschrieben. Es zeigen:
- Fig. 1: Schematisch einen Schnitt durch ein Gehäuseseitenteil aus einem geraden Abdeckblech, in welches ein Oberteil und ein Unterteil aus abgewinkeltem Abdeckblech eingesteckt sind;
- Fig. 2: schematisch eine Innenansicht auf ein Gehäuseseitenteil mit Kontaktfedern und einem separaten Anschlag für ein abgewinkeltes Blech;
- Fig. 3: schematisch einen Schnitt durch die Darstellung von Fig. 2;
- Fig. 4: schematisch einen stark vergrösserten Ausschnitt einer Kontaktfeder im Schnitt und als Innenansicht; und
- Fig. 5: schematisch eine Variante zu Fig. 1 mit einem im abgewinkelten Blech herausgebogenen Tiefenanschlag.

In den Figuren sind Baugruppenträger mit einem geraden und mit einem abgewinkelten Abdeckblech 1, 2 gezeigt, die eine Winkelverbindung für ein Gehäuse in den Abmessungen der Normen IEC 297 und IEC 917 bilden. Auf der Innenseite vom geraden Blech sind Haken 3 herausgebogen, um einen Schenkel 4 des abgewinkelten Blechs 2 darin aufzunehmen. An die Haken sind elastische Kontaktfedern angeformt, um auf dem eingeschobenen Schenkel eine vorgegebene Kontaktkraft zu erzeugen. Die Blechstärke und Abmessungen von Kontaktfeder und Haken sind so aufeinander abgestimmt, dass die Haken innerhalb eines Abstandes l < 16 mm von einer Kante 5 des geraden Blechs 1 untergebracht werden können.

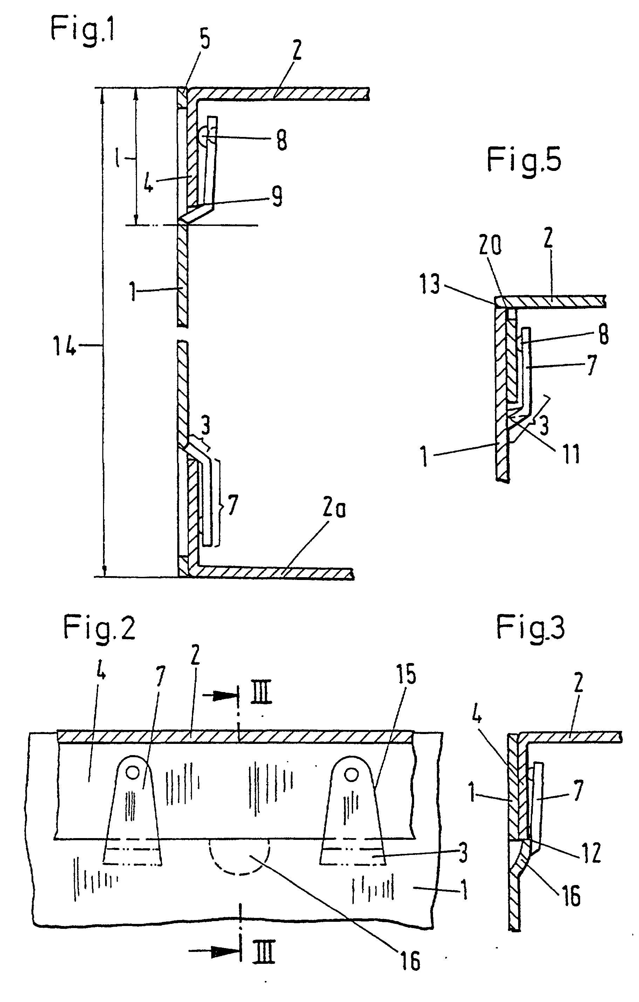

In Fig. 1 sind ein abgewinkeltes Bodenblech 2a und ein abgewinkeltes Deckblech 2 mit ihren abgewinkelten Schenkeln 4 auf der Innenseite eines geraden Seitenblechs 2 in herausgebogene Haken 3 eingesteckt, die als elastische Kontaktfedern 7 forgesetzt sind. Die Schenkel 4 liegen mit ihrem Ende jeweils am Grund 9 der Haken 3 auf. Die Haken 3 sind als elastische Kontaktfedern 7 fortgesetzt, die einen linsenförmigen Noppen 8 besitzen. Beim Einschieben der Schenkel 4 werden die Noppen an dieser linsenförmigen Fläche zurückgedrängt und gleichzeitig wird die zugehörige Kontaktfeder auf eine vorgegebene Kontaktkraft vorgespannt. Die Eintauchtiefe der Schenkel 4 ist so bemessen, dass die abgewinkelten Bleche 2, 2a mit der Höhe 14 des geraden Blechs 1 abschliessen. Dadurch, dass die Wurzeln der im Seitenblech 1 herausgebogenen Haken innerhalb einer Länge l < 16 mm von der Kante 5 des Seitenblechs entfernt sind und gleichzeitig ausreichende und beim Stecken wiederholbare Kontaktkräfte erzeugt werden, ist eine Verbindung auf der Innenseite des Gehäuses entstanden, die von aussen mechanisch nicht gestört werden kann, während sich aussen keine über das Seitenblech vorstehende Vorsprünge oder Angriffspunkte ergeben. Derartig glatte Aussenflächen von Gehäusen und deren Kanten erleichtern das "handling" enorm.

In den Fig. 2 und 3 sind in einer Seitenwand 1 zusätzlich balkonähnliche Durchrisse 16 nach innen angebracht, an denen die Schenkel 4 der abgewinkelten Bleche 2 auf einem Anschlag 12 aufliegen, um bei dünnen Seitenblechen 1 die entsprechend schwächeren Haken 3 gegenüber Kräften in der Richtung der Schenkel 4 zu entlasten. Fig. 5 zeigt eine ähnliche Anordnung wie Fig. 3. Am abgewinkelten Blech 2 sind im Knick einzelne Schultern 20 herausgebogen die auf Anschlägen 13 aufliegen, welche als Vertiefung in die Kante des geraden Blechs 1 eingelassen sind. Die Haken 3 sind zur Verstärkung mit einer Sicke 11 versehen, um eine stabile Basis für die Fortsetzung als Kontaktfeder 7 mit ihrem Noppen 8 zu bilden.

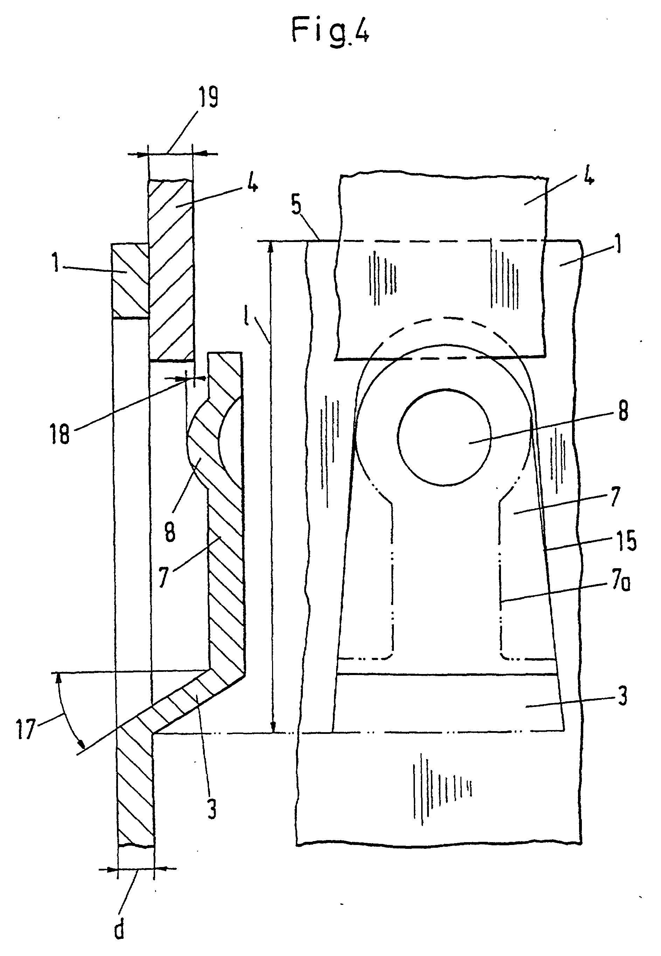

In Fig. 4 sind Details einer Ausführung nach Fig. 1 stark vergrössert dargestellt. Ein Haken 3 ist im Abstand l < 16 mm in einem Winkel 17 auf die Innenseite vom geraden Abdeckblech 1 herausgebogen und parallel zum geraden Blech 1 als Kontaktfeder 7 weitergeführt, die im oberen Bereich zu einem Noppen 8 gegen die Aussenseite ausgestülpt ist. Haken 3, Kontaktfeder 7 und Noppen 8 können in einem Werkzeug in einem Hub zunächst als Durchriss ausgetrennt und am Ende vom Hub zu ihrer endgültigen Form plastisch deformiert werden. Dies hat den Vorteil, dass alle für die Kontaktkraft wesentlichen Masse d.h. die Kontur und Lage vom Noppen 8 relativ zur Innenwand des geraden Abdeckblechs 1 an einem zusammenhängenden Teil und mit einer bestimmten Werkzeugeinstellung in hoher Wiederholgenauigkeit herstellbar sind. Die Toleranzfelder für die Wandstärke 19 vom Schenkel 4 und für die Lage vom höchsten Punkt des Nockens 8 sind so gewählt, dass eine Überdeckung 18, die dem Deformationsweg S der Kontaktfeder am Nocken entspricht, entsteht, welche mindestens 0,05 mm beträgt. Gleichzeitig ist vorgesehen, dass die Kontaktkraft im Mittel für Aluminiumblech einen Wert 3 N ≤ P ≤ 15 N und für Stahlblech einem Wert 5 N ≤ P ≤ 30 N entspricht. Die Ausstülpung vom Noppen 8 sollte daher grösser als die für eine vorgegebene Kontaktkraft notwendige Überdeckung 18 sein, um beim Ansetzen der Schenkel 4 genügend Spielraum zu haben. Bei einer vorgegebenen Wandstärke d des geraden Abdeckblechs 1, die zwischen 0,5 und 2 mm liegen kann, muss die Kontaktfeder so elastisch ausgeführt sein, dass beim Einstecken der Schenkel keine plastische Verformung stattfindet und dass die Kontaktkraft nicht zu gross wird. Aus diesem Grund darf bei dicken Blechen mit einem grösseren Wiederstandsmoment der Kontaktfeder, die Kontaktkraft nicht zu hoch angesetzt werden.

Eine weitere Möglichkeit zur Reduktion der Kontaktkraft besteht darin, die Kontaktfeder zu verjüngen. Dies kann kontinuierlich mit einer trapezähnlichen Verjüngung 15 oder in Abschnitten 7a mit einer generellen Querschnittreduktion erfolgen.

## Patentansprüche

1. Baugruppenträger mit einem geraden und mit einem abgewinkelten Abdeckblech (1, 2) die eine Winkelverbindung für ein Gehäuse (10) in den Abmessungen der Normen IEC 297 und IEC 917 bilden, wobei aus dem geraden Blech (1) Haken (3) herausgebogen sind, um einen Schenkel (4) des abgewinkelten Blechs (2) darin aufzunehmen, **dadurch gekennzeichnet, dass** die Haken (3) in einem Abstand l < 16 mm von einer Kante (5) des geraden Blechs (1) und auf der Innenseite (6) des Gehäuses (10) herausgeformt sind, und dass an den Haken (3) eine elastische Kontaktfeder (7) angeformt ist, die mit einem Noppen (8) eine vorgegebene Kontaktfkraft auf dem eingeschobenen Schenkel (4) erzeugt.

2. Baugruppenträger nach Anspruch 1, **dadurch gekennzeichnet, dass** der Schenkel (4) des abgewinkelten Blechs (2) am Grund (9) der Haken (3) aufliegt.

3. Baugruppenträger nach Anspruch 2, **dadurch gekennzeichnet, dass** an den Haken (3) zur Versteifung eine Sicke (11) angebracht ist.

4. Baugruppenträger nach Anspruch 1, **dadurch gekennzeichnet, dass** am abgewinkelten Blech (1) oder am geraden Blech (2) ein Anschlag (12, 13) herausgebogen ist, um die Eintauchbewegung des Schenkels (4) in einem positiven Abstand zum Grund (9) der Haken (3) zu begrenzen.

5. Baugruppenträger nach einem der Ansprüche 1 bis 4, **dadurch gekennzeichnet, dass** sich die Kontaktfeder (7) vom Haken (3) zum Noppen (8) verjüngt.

6. Baugruppenträger nach einem der Ansprüche 1 bis 5, **dadurch gekennzeichnet, dass** das gerade Blech (1) aus dem Haken und Kontaktfeder (7) herausgebogen sind, eine Wandstärke d in einem Bereich von 0,5 ≤ d < 2 mm aufweist.

7. Baugruppenträger nach Anspruch 6, **dadurch gekennzeichnet, dass** der Deformationsweg S der Kontaktfeder (7) beim Einschieben des Schenkels (4) in einem Bereich 0,05 mm ≤ S ≤ 0,3 mm liegt.

8. Baugruppenträger nach Anspruch 7, **dadurch gekennzeichnet, dass** die Kontaktkraft P bei einer Kontaktfeder aus Aluminiumblech einem Wert 3 N ≤ P ≤ 15 N entspricht.

9. Baugruppenträger nach Anspruch 7, **dadurch gekennzeichnet, dass** die Kontaktkraft P einer Kontaktfeder aus Stahlblech einem Wert 5 N ≤ P ≤ 30 N entspricht.

## Claims

1. Module carrier with one flat and one angled sheet metal cover (1, 2) which form an angle connection for a housing (10) in the dimensions of the IEC 297 and IEC 917 norms, with hooks (3) being bent out from the straight sheet metal part (1) in order therein to receive a limb (4) of the angled sheet metal part (2) **characterised in that** the hooks (3) are formed at a distance l < 16 mm from an edge (5) of the straight sheet metal part (1) and on the inner side (6) of the housing (10); and in that an elastic contact spring (7) is formed on the hook (3) and produces a predetermined contact force on the inserted limb (4) with a knob (8).

2. Module carrier in accordance with claim 1, **characterised in that** the limb (4) of the angled sheet metal part (2) lies in contact at the base (9) of the hooks (3).

3. Module carrier in accordance with claim 2 **characterised in that** a bead (11) is provided at the hooks (3) for stiffening.

4. Module carrier in accordance with claim 1 **characterised in that** an abutment (12, 13) is bent out at the angled sheet metal part (2) or at the straight sheet metal part (1) in order to limit the insertion movement of the limb (4) at a positive distance from the base (9) of the hooks (3).

5. Module carrier in accordance with one of the claims 1 to 4 **characterised in that** the contact spring (7) tapers from the hook (3) to the knob (8).

6. Module carrier in accordance with one of the claims 1 to 5 **characterised in that** the straight sheet metal part (1) from which the hook and contact spring (7) are bent out has a wall thickness d in a range of 0.5 mm ≤ d ≤ 2 mm.

7. Module carrier in accordance with claim 6 **characterised in that** the deformation path S of the contact spring (7) during the insertion of the limb (4) lies in a range 0.05 mm ≤ S ≤ 0.3 mm.

8. Module carrier in accordance with claim 7 **characterised in that** the contact force P corresponds to a value 3 N ≤ P ≤ 15 N for a contact spring of a sheet aluminium part.

9. Module carrier in accordance with claim 7 **characterised in that** the contact force P corresponds to a value 5 N ≤ P ≤ 30 N for a contact spring of a sheet steel part.

## Revendications

1. Support de composant avec des tôles de blindage droite et coudée (1, 2) qui forment un assemblage angulaire pour un boîtier (10) dans les dimensions des normes IEC 297 et IEC 917, où sont recourbés de la tôle droite (1) des crochets (3) pour y recevoir une branche (4) de la tôle coudée (2), **caractérisé en ce que** les crochets (3) sont formés à une distance de 1 < 16 mm d'un bord (5) de la tôle droite (1) et sur le côté intérieur (6) du boîtier (10), et en ce qu'il est rapporté par formage aux crochets (3) un ressort de contact élastique (7) qui produit avec un téton (8) une force de contact prédéfinie sur la branche insérée (4).

2. Support de composant selon la revendication 1, **caractérisé en ce que** la branche (4) de la tôle coudée (2) repose sur le fond (9) des crochets (3).

3. Support de composant selon la revendication 2, **caractérisé en ce qu'**une moulure (11) est appliquée aux crochets (3) en vue d'un renforcement.

4. Support de composant selon la revendication 1, **caractérisé en ce qu'**il est recourbé à la tôle coudée (1) ou à la tôle droite (2) une butée (12, 13) pour limiter le mouvement de plongée de la branche (4) à une distance positive au fond (9) des crochets (3).

5. Support de composant selon l'une des revendications 1 à 4, **caractérisé en ce que** le ressort de contact (7) diminue du crochet (3) vers le téton (8).

6. Support de composant selon l'une des revendications 1 à 5, **caractérisé en ce que** la tôle droite (1), à partir de laquelle sont recourbés le crochet et le ressort de contact (7), présente une épaisseur de paroi d dans une plage de 0,5 ≤ d ≤ 2 mm.

7. Support de composant selon la revendication 6, **caractérisé en ce que** le trajet de déformation S du ressort de contact (7), lors de l'insertion de la branche (4), se situe dans une plage de 0,05 mm ≤ S ≤ 0,3 mm.

8. Support de composant selon la revendication 7, **caractérisé en ce que** la force de contact P dans le cas d'un ressort de contact en tôle d'aluminium correspond à une valeur de 3 N ≤ P ≤ 15 N.

9. Support de composant selon la revendication 7, **caractérisé en ce que** la force de contact P d'un ressort de contact en tôle d'acier correspond à une valeur de 5 N ≤ P ≤ 30 N.
